# EUROPÄISCHE PATENTSCHRIFT

(11) **EP 3 970 210 B1**
(45) Veröffentlichungstag und Bekanntmachung des Hinweises auf die Patenterteilung: **02.04.2025**
(21) Anmeldenummer: 20724742.0
(22) Anmeldetag: 27.04.2020
(51) Int. Cl.: C03C 15/00, C03C 23/00, H10K 71/00, H10K 77/10, H10K 102/00

(54) **VERFAHREN ZUR HERSTELLUNG EINES EIN TRÄGERSUBSTRAT AUFWEISENDEN DISPLAYS, EIN NACH DIESEM VERFAHREN HERGESTELLTES TRÄGERSUBSTRAT SOWIE EIN FÜR EIN FLEXIBLES DISPLAY BESTIMMTES DECKGLAS**
METHOD FOR PRODUCING A DISPLAY HAVING A CARRIER SUBSTRATE, A CARRIER SUBSTRATE PRODUCED ACCORDING TO SAID METHOD, AND A COVER GLASS INTENDED FOR A FLEXIBLE DISPLAY
PROCÉDÉ DE FABRICATION D'UNE UNITÉ D'AFFICHAGE COMPRENANT UN SUBSTRAT PORTEUR, SUBSTRAT PORTEUR FABRIQUÉ D'APRÈS CE PROCÉDÉ AINSI QUE VERRE DE COUVERTURE DESTINÉ À UNE UNITÉ D'AFFICHAGE FLEXIBLE

(30) Priorität: 13.05.2019 DE 102019112472; 20.05.2019 DE 102019113344; 04.07.2019 DE 102019118158; 30.10.2019 DE 102019129359
(43) Veröffentlichungstag der Anmeldung: 23.03.2022
(73) Patentinhaber: LPKF Laser & Electronics SE, 30827 Garbsen (DE)
(72) Erfinder: OSTHOLT, Roman, 30855 Langenhagen (DE); DUNKER, Daniel, 30419 Hannover (DE); SCHNEIDER, Sergej, 30171 Hannover (DE)
(74) Vertreter: Scheffler, Jörg
(86) Internationale Anmeldenummer: PCT/DE2020/100341
(87) Internationale Veröffentlichungsnummer: WO 2020/228893

(56) Entgegenhaltungen:
- EP-A1- 3 301 506
- WO-A2-2014/161534
- US-A1- 2017 294 495
- US-A1- 2018 150 108

## Beschreibung

Die Erfindung betrifft ein Verfahren zur Herstellung eines ein Trägersubstrat, insbesondere Glassubstrat, aufweisenden Displays mit zumindest in einem vorbestimmten Bereich des Trägersubstrats flexiblen, biegbaren und/oder elastischen Eigenschaften.

Derartige Displays, beispielsweise auf der Basis von organischen Leuchtdiode (OLED) gewinnen für Anzeigezwecke zunehmend an Bedeutung, insbesondere bei kleinen Vorrichtungen, wie mobil mitführbare Geräte, einschließlich Wert- und Sicherheitsdokumenten, da sie als sehr dünne Schichten hergestellt werden können.

Es ist bekannt, OLED-Anzeigen flexibel auszuführen. Hierzu sind bereits Verfahren zum nachträglichen Strukturieren einer flexiblen organischen lichtemittierenden Diode (FOLED) bekannt, bei dem schrittweise ein oder mehrere Schichten von der gestapelten Schichtanordnung mittels Laserstrahlung wieder abgetragen werden (Ablation).

Da diese aus Schichten von organischen Materialien auf flexiblen Trägersubstraten hergestellt werden können, einschließlich flexiblen Treiberschaltungen, lassen sie sich an nicht-ebene Oberflächen anpassen oder in Strukturen einsetzen, welche selbst flexible Eigenschaften haben.

Als problematisch erweist sich die Empfindlichkeit der OLED-Materialien auf Sauerstoff und/oder Feuchtigkeit, was in relativ kurzen Lebensdauern resultiert. Dies kann beispielsweise gelöst werden, indem die eigentlichen OLED-Komponenten zwischen zwei Glas-Schichten eingebracht werden, welche im Wesentlichen frei von Sauerstoff und/oder Dampfdiffusion sind.

Eine weitere Möglichkeit ist es, die OLED-Anzeige auf einem Glassubstrat mit einer Sperrschicht zu verwenden. Diese Sperrschichten können beispielsweise aus Siliziumoxiden (SiO2), (Bor-)Silikaten, Aluminaten (Al2O3) oder Metallschichten (AI, Ag, Au, Rh) oder anderen entsprechenden Materialien aufgebaut werden.

Derartige OLED-Strukturen oder -Vorrichtungen bleiben flexibel, falls die Glasschichten eine Dicke unterhalb bestimmter Grenzen haben. Typischerweise haben OLEDs mit Glasschichten und einer Dicke von 100 µm oder weniger immer noch die notwendige Flexibilität für die meisten Zwecke.

Allerdings sind derartige dünne Glasschichten, d. h. unter 50 µm, oder selbst unter 20 µm, zerbrechlich und neigen wegen ihrer Sprödigkeit zum Brechen. Somit ist es von diesem Aspekt her wünschenswert, derartige OLEDs zu Stabilisierungszwecken mit mechanisch festen (flexiblen oder nicht-flexiblen) Trägersubstraten zu verbinden.

Bei der Produktion von klassischen Displays für Smartphones wird ein Trägersubstrat aus Glas als unterste Schicht verwendet, die sogenannte "Back Plane". Die Eigenschaften von technischen Gläsern sind ideal für die Anforderungen an ein Back Plane.

Mit der Entwicklung von faltbaren Displays für neuartige Smartphones ging eine signifikante Änderung der Prozessabfolge einher. Die ursprünglich zur Stabilisierung und Fixierung der elektronischen Komponenten gedachten Back Planes aus Glas müssen in der aktuellen Herangehensweise nach der Aufbringung der Komponenten in einem aufwendigen und den Ausschuss erhöhenden Verfahren (Laser-Lift-Off-Verfahren) entfernt werden. Auf diese Weise bleiben nur die biegsamen Komponenten des Displays ohne die schützende Back Plane zurück

Beim Laser-Lift-Off-Verfahren geht es um den Transfer einer mikroelektronischen Funktionsschicht auf ein neues Trägersubstrat, welches leichter und dünner ist. Die Trennung der Schichten erfolgt dabei meistens durch selektive Laserablation und Verdampfen einer stark absorbierenden Zwischenschicht, typischerweise einer Polymerschicht. Entscheidend ist, die angrenzende mikroelektronische Funktionsschicht durch die Energie der Laserstrahlung nicht zu beeinträchtigen.

Die Produktion flexibler Displays, ob sie in einem Smartphone, Tablet oder E-Reader zum Einsatz kommen, haben immer eines gemeinsam: Die Schaltkreisschichten zur individuellen Pixel-Steuerung befinden sich nicht mehr auf einem festen Glasträger, sondern auf einer biegsamen Schicht.

Nachteile des herkömmlichen Laser-Lift-Off-Verfahrens sind die hohen Prozesszeiten/Produktionskosten und der Ausschuss, der durch das Verfahren zusätzlich entsteht, da Displays bei diesem Verfahren beschädigt werden können.

Derartige flexible Anzeigevorrichtungen sind beispielsweise aus der EP 3206108 B1, EP 3456036 A1, US 2017/294495 A1, EP 3 301 506 A1, US 2018/150108 A1 oder der EP 2709091 B1 bekannt.

Weiterhin bezieht sich die US 2016/ 0 057 834 A1 auf ein Verfahren zur Herstellung eines Substrats für ein Anzeigemodul. Ein Substratkörper mit einem Signalschaltungsbereich wird auf eine transparente Trägerplatte aufgebracht. In den Substratkörper werden eine Vielzahl von Öffnungen eingebracht und eine untere Oberfläche durch hochenergetisches Licht durch die transparente Trägerplatte geätzt, um den Substratkörper von der transparenten Trägerplatte zu trennen.

Die JP 2013-009016 A bezieht sich auf eine Vielzahl von Dünnfilmelementen auf einer Halbleiterschicht, bei dem eine Ätzrille durch Laserätzen zwischen einer Vielzahl von Dünnfilmelementen eingebracht ist.

Die Aufgabe der vorliegenden Erfindung besteht darin, ein Trägersubstrat für ein Display zu schaffen, welches flexible Eigenschaften auch bei einer vergleichsweise großen Materialstärke aufweist.

Diese Aufgabe wird mit einem Verfahren nach Anspruch 1 gelöst. Bevorzugte Ausgestaltungen sind in den Unteransprüchen angegeben.

Erfindungsgemäß werden zumindest in einem vorbestimmten Bereich des Trägersubstrats flexible oder elastische Eigenschaften mit dem erfindungsgemäßen Verfahren dadurch realisiert, dass zunächst innerhalb des Bereichs des Trägersubstrats, der die gewünschten flexiblen Eigenschaften erhalten soll, mittels Laserstrahlung Modifikationen entlang einer geschlossenen und somit einen Teilbereich des Trägersubstrats einschließenden Kontur oder entlang einer linienförmigen Kontur in das Trägersubstrat insbesondere über dessen gesamte Breite eingebracht werden. Zumindest eine flexible Schicht wird auf das Trägersubstrat zumindest in dem zu erzeugenden flexiblen Bereich des Trägersubstrats, vorzugsweise jedoch auch auf angrenzende Bereiche des Trägersubstrats, aufgebracht.

Anschließend wird das Trägersubstrat einem Ätzangriff ausgesetzt. Es kommt zu einem Materialabtrag des Trägersubstrats entlang der geschlossenen und/oder linienförmigen Kontur der lasermodifizierten Bereiche, sodass entweder Teilbereiche des Trägersubstrats herausgelöst oder schlitzförmige Einschnitte als Ausnehmungen erzeugt werden.

Diese Ausnehmungen erstrecken Sich bevorzugt über einen Großteil der gesamten Dicke des Trägersubstrats, zwischen der Schicht auf dem Trägersubstrat und einer der Schicht abgewandten Außenfläche des Trägersubstrats.

Die so erzeugten Ausnehmungen bilden einen flexiblen Bereich, der als Festkörpergelenk realisiert ist. In einer Ausführungsform kann das Festkörpergelenk als Torsionsgelenk ausgebildet sein und besteht hierzu zumindest abschnittsweise aus zumindest einem Bereich, der tordiert bzw. verdreht werden kann.

Im Gegensatz zum Stand der Technik geht die Erfindung davon aus, dass anstatt die gläsernen Back Planes zu entfernen, diese selektiv vor der Displayfertigung an ausgewählten Stellen mit einem Laser modifiziert werden. Die modifizierten Bereiche zeichnen aus, dass diese zielgerichtet und wesentlich schneller als nicht-modifizierte Bereiche durch nasschemische Verfahren entfernt werden können. Durch die Laser-Modifikation wird die Integrität des Trägersubstrats aus Glas nicht maßgeblich verschlechtert, so dass dieses weiterhin in dem darauffolgenden Displayfertigungsprozess verwendet werden kann.

Auf das Trägersubstrat wird dann eine dünne Metallschicht, insbesondere eine Chromschicht als Haftvermittler sowie eine Kupferschicht als Ätzresist, aufgebracht. Alternativ kann an dieser Stelle auch eine Polymerschicht aufgebracht werden. Beide möglichen Schichten haben gemein, dass diese eine zumindest begrenzte Haltbarkeit gegenüber nasschemischen Ätzlösungen besitzen und gleichzeitig flexibel genug sind, um gefaltet zu werden.

Vorzugsweise überdecken die Metallschicht oder die Polymerschicht den zu erzeugenden flexiblen Bereich des Trägersubstrats sowie daran angrenzende Bereiche des Trägersubstrats, beispielsweise auch die gesamte Trägersubstratfläche.

Nach Abschluss der additiven Prozesse der eigentlichen Displayfertigung, insbesondere dem Aufbringen vorzugsweise mehrerer Schichten sowie elektrischer und optischer Komponenten, wird eine Verkapselung des Displays vorgenommen.

Anstatt wie beim Stand der Technik abtragende oder trennende Verfahren für die Glas-Back-Plane durchzuführen, wird erfindungsgemäß das gesamte Display einer nasschemischen Ätzlösung ausgesetzt. Diese verursacht zum einen, dass die Dicke der Glas-Back-Plane auf einen gewünschten Wert verringert wird und zum anderen, dass die zuvor lasermodifizierten Bereiche entfernt werden. Die Verkapselung des Displays sorgt dafür, dass die sensiblen Bereiche des Displays vor einer Beeinträchtigung durch die Ätzlösung geschützt bleiben.

Entsprechend den verwendeten Modifikationsgeometrien lassen sich flexible Trägersubstratbereiche erstellen oder ganze Teilbereiche des Trägersubstrates entfernen, so dass an dieser Stelle nur die flexiblen, biegsamen Displaybereiche vorhanden sind. Auf diese Weise wird erreicht, dass das Display sowohl flexible als auch feste Bereiche besitzt.

Das nasschemische Bearbeiten mit Flusssäure oder vergleichbaren Mitteln ist für sich genommen aus dem Stand der Technik bei der Herstellung von festen Displays bekannt.

Die später als Back Plane zu verwendenden technischen Gläser als Trägersubstrat werden als erster Prozessschritt lasermodifiziert. Je nach gewünschter Anwendung kann so das Glassubstrat auf verschiedene Weisen modifiziert und die Faltung des Displays unterstützt werden. Eine Herangehensweise ist das Herstellen von Schnitten und Bohrungen in dem Glassubstrat entsprechend vorbestimmten Geometrien.

Sofern beispielsweise der flexible Bereich des Trägersubstrats von nicht flexiblen Trägersubstratbereichen eingeschlossen ist, bleibt das Glassubstrat am Ende als stabilisierendes Material vorhanden. Dadurch werden Bereiche definiert, die entweder starr oder flexibel sind.

Eine weitere Möglichkeit besteht darin, das Glassubstrat entlang der zu erzeugenden Faltungsstrecke mit einer Vielzahl paralleler Konturen als Schnittlinien zu versehen und die Flexibilität nur über die unter dem Glas liegenden flexiblen elektronischen und optischen Komponenten zu gewährleisten.

Diese Variante lässt sich derart weiterentwickeln, dass ein von der Kontur eingeschlossener Bereich des Glassubstrats vollständig entfernt wird.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in einer Prinzipdarstellung
- Fig. 1: eine geschnittene Seitenansicht eines für ein flexibles Display bestimmten Trägersubstrats mit zumindest einer überdeckenden Schicht;
- Fig. 2: eine Draufsicht auf ein mit linienförmigen Modifikationen versehenes Trägersubstrat;
- Fig. 3: eine Draufsicht auf ein Variante des Trägersubstrats mit randseitigen Modifikationen;
- Fig. 4: die Verfahrensschritte bei der Herstellung des Displays:
- Fig. 5: eine Draufsicht auf ein durch Schnitte gebildetes Torsionsgelenk;
- Fig. 6: eine Draufsicht auf einen flexiblen Bereich und daran angrenzende Bereiche;
- Fig. 7: die Verfahrensschritte zur Herstellung eines Trägersubstrats einer Variante des Verfahrens mit einer polymeren Zwischenschicht;
- Fig. 8: die Verfahrensschritte zur Herstellung eines Trägersubstrats einer weiteren Variante des Verfahrens mit einer polymeren Zwischenschicht;
- Fig. 9: die Verfahrensschritte zum Aufbringen einer polymeren Schicht auf ein mit Durchgangsöffnungen versehenes Trägersubstrat.

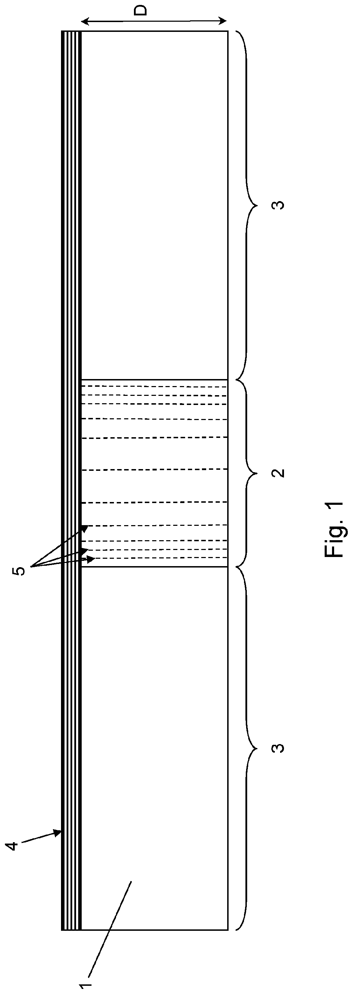

Figur 1 zeigt ein zur Herstellung eines flexiblen oder faltbaren Displays bestimmtes Trägersubstrat 1 aus Glas, wobei das Trägersubstrat 1 einen zentralen flexiblen Bereich 2 sowie beiderseits daran anschließende unflexible bzw. starre Randbereiche 3 aufweist. Alle Bereiche 2, 3 sind durch einen Schichtaufbau aus mehreren, in einzelnen Ebenen aufgebrachten Schichten 4 abgedeckt, wobei der Schichtaufbau seinerseits ebenfalls flexible Eigenschaften aufweist.

Die starren Randbereiche 3 weisen eine Materialstärke D von mehr als 100 µm auf. Mit diesen Randbereichen 3 einteilig bzw. monolithisch verbunden ist der zentrale Bereich 2, welcher mit Modifikationen 5 ausgestattet ist, die infolge eines nachfolgenden Ätzverfahrens Ausnehmungen 6 bilden, die in dem dargestellten Ausführungsbeispiel eine Beweglichkeit nach der Art eines Festkörpergelenks ermöglichen. Die in diesem Bereich 2 zu erzeugenden Ausnehmungen 6 können in Form von Gräben, Schnitten und/oder Bohrungen eingebracht werden, oder aber das Trägersubstratmaterial wird in diesem Bereich vollständig entfernt.

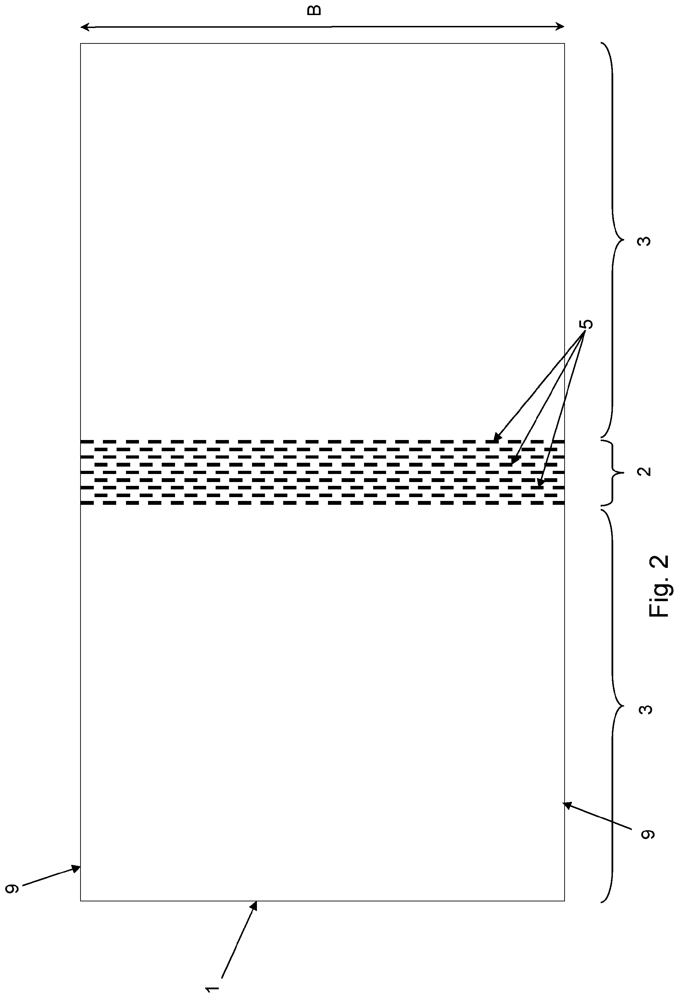

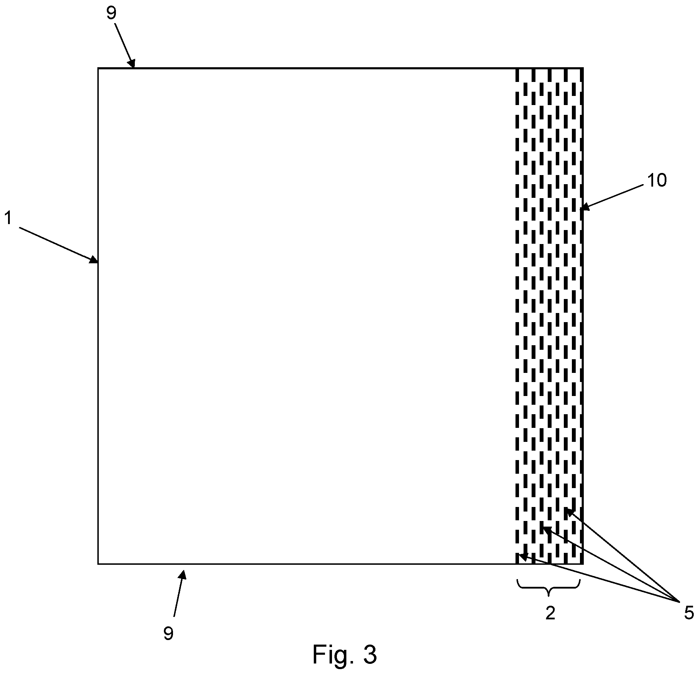

Die Figuren 2 und 3 zeigen jeweils eine Draufsicht auf das Trägersubstrat 1. Wie zu erkennen, verlaufen die Modifikationen 5 in dem flexiblen Bereich 2 über die gesamte Breite B des Trägersubstrats 1 zwischen einander gegenüberliegenden Seitenrändern 9 des Trägersubstrats 1, sodass eine homogene Materialschwächung und somit Beweglichkeit über die gesamte Breite B des auf dem Trägersubstrat 1 aufgebauten Displays zu erreichen.

Während sich bei der Variante gemäß der Figur 2 starre Randbereiche 3 beiderseits des flexiblen Bereichs 2 anschließen, ist in der Figur 3 noch ein Variante dargestellt, bei welcher der flexible Bereich 2 im Randbereich des Trägersubstrats 1 liegt, welches sich dem starren Randbereich 3 anschließt und somit einen Randabschluss 10 des Trägersubstrats 1 bildet.

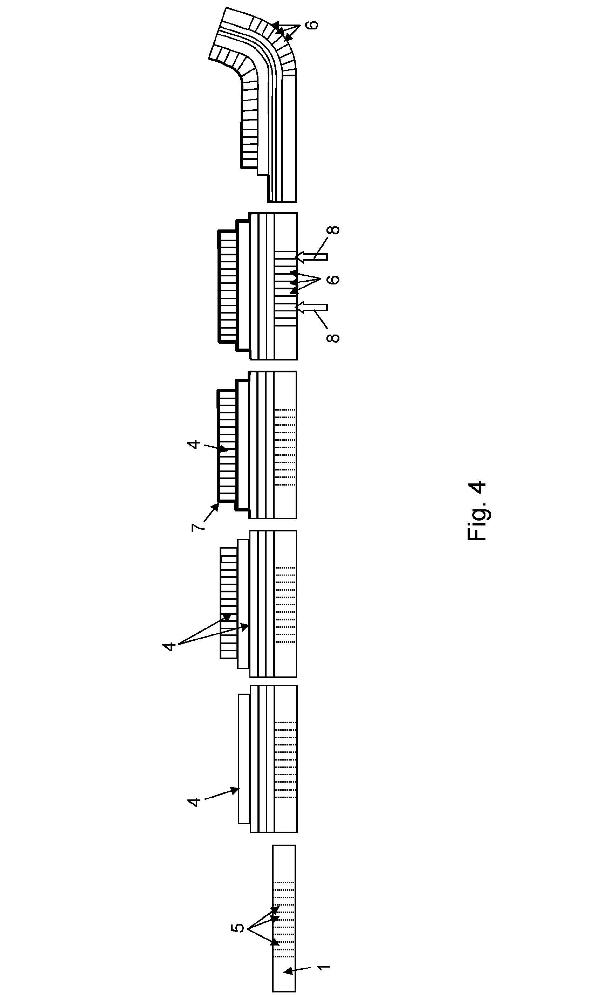

Die einzelnen Verfahrensschritte zur Erzeugung der Kontur werden nachstehend anhand der Figur 4 näher erläutert. Ausgehend von der Modifikation des Trägersubstrats1 in dem zentralen Bereich wird anschließend die Oberfläche des Trägersubstrats 1 in einer PVD-Anlage mit einer dünnen Schicht 4 aus Chrom und Kupfer bedampft und die Kupferschicht in einer Galvanik-Anlage nachträglich auf eine Dicke von mehreren Mikrometern verstärkt, bis sich eine durchgängige aber biegsame Schicht 4 bildet.

Die Abscheidung der Schicht 4, beispielsweise als Seed Layers auf das modifizierte Trägersubstrat, erfolgt mittels Magnetronsputtern (PVD-Verfahren). Das Trägersubstrat 1 wird mit der Unterseite nach oben in die PVD-Anlage platziert und die Kammer evakuiert. Nach dem Erwärmen des Trägersubstrats 1 auf eine Temperatur von ca. 200°C werden eine ca. 100 nm dicke Schicht 4 Chrom und anschließend eine ca. 350 nm dicke Schicht 4 Kupfer auf der Trägersubstratoberfläche abgeschieden. Nach dem Abkühlen des Trägersubstrats 1 auf ca. 100°C wird die Kammer belüftet und das Trägersubstrat 1 entnommen.

Als nächstes wird die Seed Layer-Schicht des Glassubstrats galvanisch verstärkt. Hierfür wird das Trägersubstrat 1 in einem Waferhalter fixiert und mit Hilfe eines Galvaniksystems ca. 5 µm Kupfer auf den Seed Layer abgeschieden. Anschließend wird das Trägersubstrat 1 mit VE-Wasser abgespült und mittels Trockenluft getrocknet.

Nach Abschluss der additiven Prozesse der eigentlichen Displayfertigung, insbesondere dem Aufbringen vorzugsweise mehrerer Schichten 4 sowie elektrischer und optischer Komponenten, wird eine Verkapselung durch Aufbringen einer Deckschicht 7 des Displays vorgenommen.

Es folgt das Ätzen des Trägersubstrats 1 in einer Lösung aus Flusssäure über einen Zeitraum von etwa 120 Minuten bei 5% HF-Lösung, bis mindestens die gesamten modifizierten Bereiche 2 ätztechnisch entfernt wurden. Eine Fortführung des Ätzdurchgangs um einige Mikrometer darüber hinaus erhöht die Zuverlässigkeit des Systems.

Nicht gezeigt ist der in der Praxis zusätzliche zwischen der Modifikation und dem Schichtauftrag (Polymer oder Metall) und dem nasschemischen Ätzschritt durchzuführende Prozess zur Herstellung des eigentlichen Displays.

Nach Abschluss des einseitigen Ätzangriffs 8 entsteht ein bereichsweise faltbares Trägersubstrat 1 aus Glas, welches fest mit einer durchgängigen, ebenfalls faltbaren Metallschicht verbunden ist. Das Entfernen der gläsernen Back Plane ist mit dieser Variante nicht mehr notwendig. Dementsprechend wird der Produktionsablauf um einen Ausschuss produzierenden Prozessschritt reduziert.

Je nach Variante wird durch das teilflexible Back Plane-Glas das Display selbst unterstützt und ist weniger anfällig für Beschädigungen.

Zusammenfassend lassen sich die wesentlichen Verfahrensschritte zur Herstellung eines Displays unter Verwendung des Glassubstrats 1 wie folgt beschreiben:
1. Bereitstellung eines starren Glassubstrats 1
2. Einbringen von Modifikationen 5 durch Laserstrahlung in das Glassubstrat 1
3. Aufbringen des Schichtaufbaus aus mehreren Schichten 4
4. Aufbringen einer Deckschicht 7 zur Verkapselung des Schichtaufbaus
5. zumindest einseitiges Ätzen des Glassubstrats 1 zur Erzeugung von Mikrostrukturen mit Ausnehmungen 6 zur Ausbildung des Festkörpergelenks

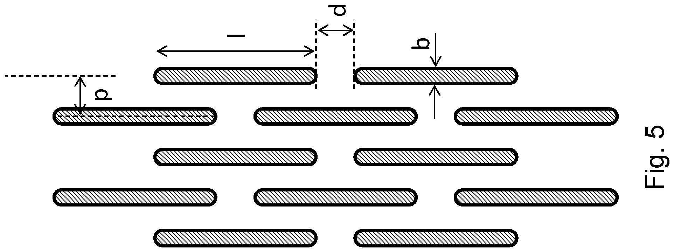

Die Figur 5 zeigt in einer Draufsicht ein durch Schnitte gebildetes Torsionsgelenk, bei dem zumindest einzelne Schnitte eine Breite b von weniger als 100 µm und eine Länge von I größer als 300 µm aufweisen, wobei die Schnitte durch Stege der Breite p größer als 100 µm voneinander parallel beabstandet sind. In Längsrichtung weisen benachbarte Schnitte einen Abstand von d größer als 100 µm auf.

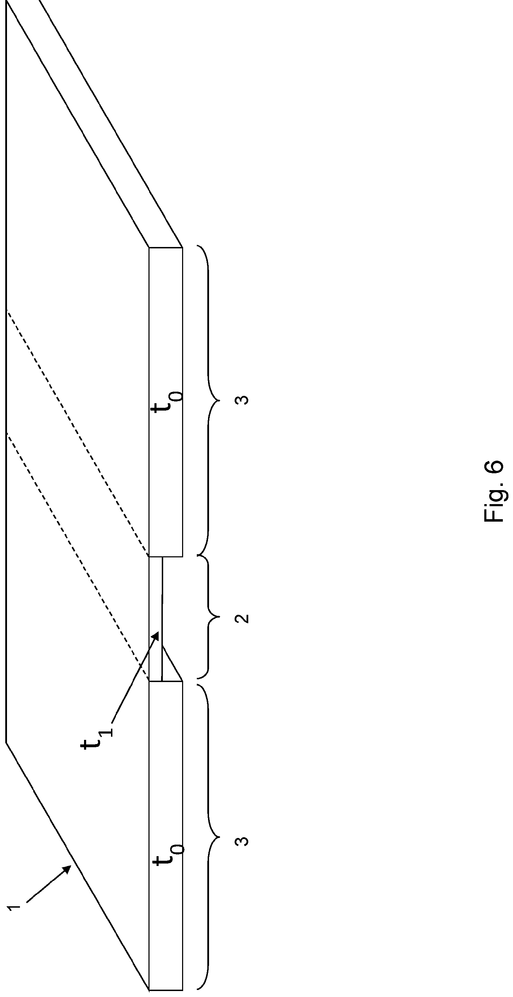

In der Figur 6 ist eine Draufsicht auf einen flexiblen Bereich 2 und daran angrenzende Bereiche 3 dargestellt, wobei der flexible Bereich 2 dadurch gebildet wird, dass die Materialstärke t₀ durch den Ätzangriff nur im Bereich der Modifikationen 5 auf eine Stärke t₁ verringert wird, bei der das Trägersubstrat 1 flexibel wird.

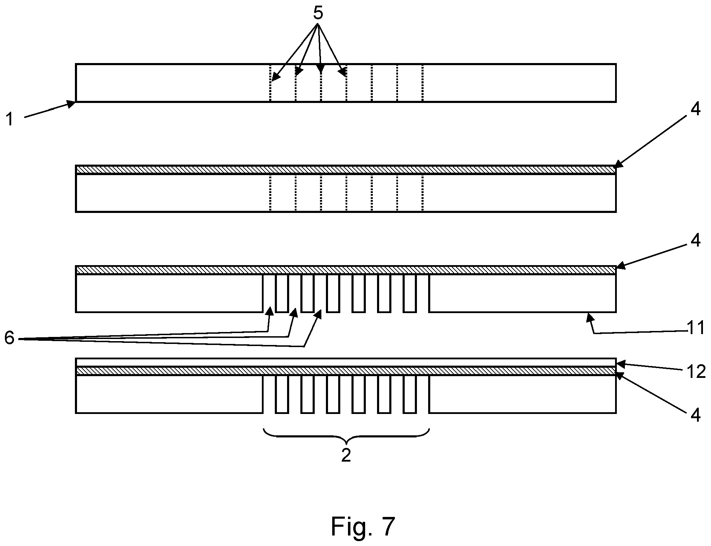

Die Figur 7 zeigt eine Variante des Verfahrens zur Herstellung des in dem zentralen Bereich 2 flexiblen Trägersubstrats 1 aus Glas mit einer Materialstärke von ca. 200 µm. Hierzu werden zunächst innerhalb des Bereichs 2 des Trägersubstrats 1 mittels Laserstrahlung Modifikationen 5 in das Trägersubstrat 1 eingebracht, ohne dass es dabei bereits zu einem Materialabtrag in dem Trägersubstrat 1 kommt. Im nächsten Schritt wird das Trägersubstrat 1 einseitig mit einer vorzugsweise transparenten Schicht 4 aus einem Polymer mit einer Dicke von einigen µm beschichtet, wobei das Polymer beispielsweise in einem flüssigen Zustand aufgetragen wird und anschließend vor der Weiterverarbeitung aushärtet. Dabei behält die Schicht 4 ihre flexiblen oder elastischen Eigenschaften. Der so geschaffene Verbund wird anschließend einem Ätzangriff ausgesetzt, wobei die polymere Schicht 4 als Ätzresist wirkt. Dadurch kommt es zu dem Materialabtrag in dem Trägersubstrat 1 beginnend mit einer abgewandten Außenfläche 11 entsprechend der zuvor eingebrachten Modifikationen 5 der lasermodifizierten Bereiche 2 durch einen anisotropen Materialabtrag, bis sich die so erzeugten Ausnehmungen 6 zwischen der Schicht 4 und der der Schicht 4 abgewandten Außenfläche 11 des Trägersubstrats 1 erstrecken. Schließlich wird ein flexibles Glassubstrat 12, beispielsweise kongruent zu dem Trägersubstrat 1, auf die polymere Schicht 4 aufgebracht.

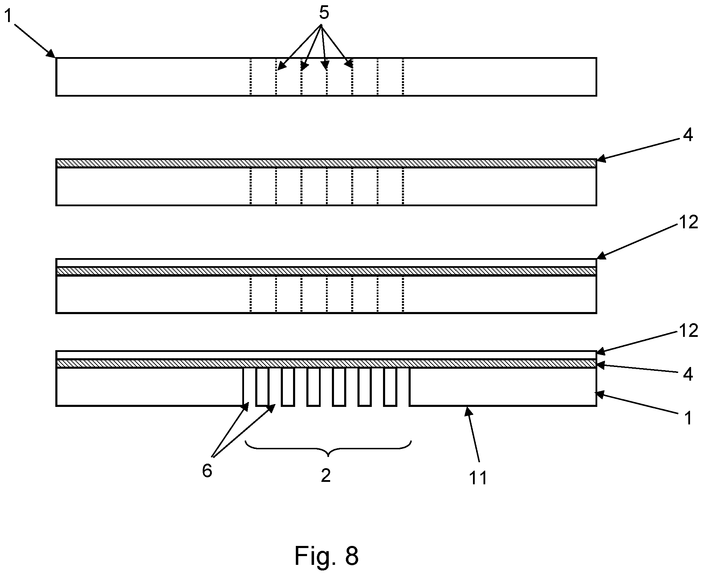

In der Figur 8 ist eine weitere Variante des Verfahrens dargestellt. Dabei wird vor der Durchführung des Ätzverfahrens ein Materialverbund als Verbundglas hergestellt, wobei das mit den Modifikationen 5 versehene Trägersubstrat 1 durch die polymere adhäsive Schicht 4 mit dem flexiblen Glassubstrat 12 verbunden ist. Anschließend wird der Materialverbund aus dem Trägersubstrat 1, Glassubstrat 12 und der polymeren Schicht 4 einem Ätzangriff ausgesetzt, wobei der Materialabtrag des Trägersubstrats 1 entlang der Modifikationen 5 in dem Trägersubstrat 1 anisotrop voranschreitet, bis sich die so erzeugten Ausnehmungen 6 zwischen der Schicht 4 und der der Schicht 4 abgewandten Außenfläche 11 des Trägersubstrats 1 erstrecken. Indem das Verbundglas mit dem außenliegenden Trägersubstrat 1 sowie dem außenliegenden Glassubstrat 12 dem Ätzangriff ausgesetzt wird, sind ätzresistente Eigenschaften der eingeschlossenen polymeren Schicht entbehrlich.

Zudem kann auch das flexible Glassubstrat 12 Modifikationen aufweisen, die in dem Ätzbad einem anisotropen Materialabtrag ausgesetzt werden, sodass in einem gemeinsamen Verfahrensschritt die gewünschten Strukturen in dem Trägersubstrat 1 und dem Glassubstrat 12 erzeugt werden.

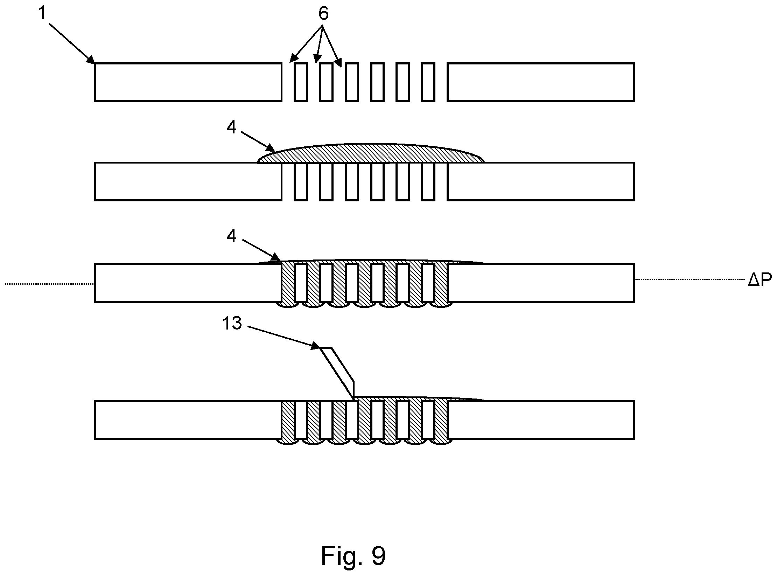

In der Figur 9 ist weiterhin noch ein optimiertes Verfahren zum Aufbringen der polymeren Schicht 4 auf ein mit Durchgangsöffnungen als Ausnehmungen 6 versehenes Trägersubstrat 1 dargestellt. Hierbei wird die polymere Schicht 4 in einem fließfähigen Zustand auf den mit den Ausnehmungen 6 versehenen Bereich des Trägersubstrats 1 als Flüssigpolymer aufgetragen und durch Anlegen einer Druckdifferenz Δp durch die Ausnehmungen 6 hindurchgepresst bzw. gesaugt. Anschließend wird die Schicht 4 durch UV-Härten des polymeren Materials hergestellt und ausgehärtet. Zumindest eine ebene Außenfläche 11 kann durch Abtragen des überschüssigen Schichtmaterials, beispielsweise mittels eines Abtragwerkzeuges 13, erzeugt werden.

## Patentansprüche

1. Verfahren zur Herstellung eines Trägersubstrats (1) aus Glas für ein Display mit zumindest in einem vorbestimmten Bereich (2) des Trägersubstrats (1) flexiblen, biegbaren und/oder elastischen Eigenschaften, bei dem mehrere Ausnehmungen (6) mittels eines Ätzverfahrens infolge eines Materialabtrags in das Trägersubstrat (1) eingebracht werden, indem innerhalb des Bereichs (2) des Trägersubstrats (1) mittels Laserstrahlung Modifikationen (5) entlang mindestens einer geschlossenen und/oder linienförmigen Kontur und/oder punktuelle Modifikationen (5) in das Trägersubstrat (1) eingebracht werden und zumindest innerhalb des Bereichs (2) zumindest eine flexible, biegbare und/oder elastische Schicht (4) auf das Trägersubstrat (1) aufgebracht wird und nachfolgend eine der Schicht (4) abgewandte Seite des Trägersubstrats (1) einem Ätzangriff ausgesetzt wird, durch den der Materialabtrag des Trägersubstrats (1) entlang der geschlossenen und/oder linienförmigen Kontur und/oder der punktuellen Modifikation (5) der lasermodifizierten Bereiche (2) erfolgt, bis sich die so erzeugten Ausnehmungen (6) zumindest über einen wesentlichen Teil der Materialstärke (D) des Trägersubstrates (1), insbesondere zwischen der Schicht (4) und einer der Schicht (4) abgewandten Außenfläche (11) des Trägersubstrats (1) erstrecken und dadurch ein Festkörpergelenk bilden.

2. Verfahren nach Anspruch 1, **dadurch gekennzeichnet, dass** auf das Trägersubstrat (1) eine Opferschicht als Träger der Schicht (4) aufgebracht wird, und dass der Ätzvorgang fortgesetzt wird, bis die Opferschicht erreicht wird, sodass es zu einer Auflösung oder Reduzierung der Opferschicht und schließlich zu einem Trennen der Verbindung der durch die Kontur begrenzten Fläche des Trägersubstrats (1) von dem umgebenden Glassubstrat sowie von der Schicht (4) kommt.

3. Verfahren nach Anspruch 1 oder 2, **dadurch gekennzeichnet, dass** in dem Bereich (2) des Trägersubstrats (1) mehrere parallele Konturen erzeugt werden.

4. Verfahren nach zumindest einem der vorhergehenden Ansprüche, **dadurch gekennzeichnet, dass** als Schicht (4) ein Dünnschichtbauelement insbesondere eine organische Leuchtdiode (OLED) aufgebracht wird und/oder dass die Schicht (4) als Träger des Dünnschichtbauelements dient.

5. Verfahren nach zumindest einem der vorhergehenden Ansprüche, **dadurch gekennzeichnet, dass** die Modifikationen (5) vor dem Aufbringen der Schicht (4) in das Trägersubstrat (1) eingebracht werden und/oder der Ätzprozess nach Abschluss des Schichtauftrags durchgeführt wird.

6. Verfahren nach zumindest einem der vorhergehenden Ansprüche, **dadurch gekennzeichnet, dass** die Schicht (4) sowohl auf den durch den Materialabtrag flexiblen Bereich des Trägersubstrats (1) als auch auf angrenzende Bereiche des Trägersubstrats (1) aufgebracht wird.

7. Verfahren nach zumindest einem der vorhergehenden Ansprüche, **dadurch gekennzeichnet, dass** der Ätzangriff mittels eines Ätzresists auf einen Teilbereich des Trägersubstrats (1) beschränkt wird.

8. Verfahren nach zumindest einem der vorhergehenden Ansprüche, **dadurch gekennzeichnet, dass** die Ausnehmungen im flexiblen Bereich mit einem flexiblen und/oder dehnbaren Polymer gefüllt werden.

9. Ein für ein flexibles Display bestimmtes Deckglas (1) aus Glas mit zumindest einem flexiblen Bereich (2), in dem mehrere Ausnehmungen (6) mittels eines Ätzverfahrens infolge eines Materialabtrags in das Deckglas (1) eingebracht sind, hergestellt, indem innerhalb des herzustellenden flexiblen Bereichs (2) des Deckglases (1) mittels Laserstrahlung Modifikationen (5) entlang mindestens einer geschlossenen und/oder linienförmigen Kontur und/oder punktuelle Modifikationen (5) in das Deckglas (1) eingebracht werden und nachfolgend das Deckglas (1) einem Ätzangriff ausgesetzt wird, durch den der Materialabtrag des Deckglases (1) entlang der mindestens einen geschlossenen und/oder linienförmigen Kontur und/oder an den punktuellen Modifikationen (5) der lasermodifizierten Bereiche (2) erfolgt, bis sich die so erzeugten Ausnehmungen (6) zumindest über einen wesentlichen Teil der Materialstärke des Deckglases (1) erstrecken und im flexiblen Bereich (2) ein Festkörpergelenk entstanden ist.

10. Verfahren nach zumindest einem der vorhergehenden Ansprüche 1 bis 8 oder Deckglas nach Anspruch 9, **dadurch gekennzeichnet, dass** das Festkörpergelenk ein Torsionsgelenk ist.

11. Verfahren oder Deckglas nach Anspruch 10, **dadurch gekennzeichnet, dass** das Torsionsgelenk durch Schnitte gebildet wird, von denen zumindest einzelne eine Breite b<100 µm aufweisen.

12. Verfahren oder Deckglas nach Anspruch 11, **dadurch gekennzeichnet, dass** die Schnitte durch Stege der Breite p>100 µm voneinander beabstandet sind.

13. Verfahren oder Deckglas nach Anspruch 11 oder 12, **dadurch gekennzeichnet, dass** die Schnitte eine Länge von I>300 µm aufweisen.

14. Verfahren oder Deckglas nach zumindest einem der Ansprüche 11 bis 13, **dadurch gekennzeichnet, dass** die Schnitte entlang ihrer langen Erstreckung einen Abstand von d>100 µm aufweisen.

15. Verfahren oder Deckglas nach zumindest einem der Ansprüche 11 bis 14, **dadurch gekennzeichnet, dass** die Länge I der Schnitte mindestens dreimal so groß ist wie der Abstand d.

16. Verfahren oder Deckglas nach zumindest einem der vorhergehenden Ansprüche, **dadurch gekennzeichnet, dass** der flexible Bereich dadurch gebildet wird, dass die Materialstärke (t₀) durch den Ätzangriff nur im Bereich der Modifikationen (5) auf eine Stärke (t₁) verringert wird, bei der das Trägersubstrat (1) aus Glas flexibel wird.

17. Verfahren nach zumindest einem der Ansprüche 1 bis 8 oder 10 bis 16, zur Herstellung zumindest eines Trägersubstrats (1) aus Glas mit zumindest in einem vorbestimmten Bereich (2) des Trägersubstrats (1) flexiblen, biegbaren und/oder elastischen Eigenschaften, bei dem mehrere Ausnehmungen (6) mittels eines Ätzverfahrens infolge eines Materialabtrags in das Trägersubstrat (1) eingebracht werden, indem innerhalb des Bereichs (2) des Trägersubstrats (1) mittels Laserstrahlung Modifikationen (5) entlang mindestens einer geschlossenen und/oder linienförmigen Kontur und/oder punktuelle Modifikationen (5) in das Trägersubstrat (1) eingebracht werden und zumindest innerhalb des Bereichs (2) zumindest eine flexible, biegbare und/oder elastische, insbesondere transparente, Schicht (4) aus einem Polymer auf das Trägersubstrat (1) aufgebracht wird und das Trägersubstrat (1) einem Ätzangriff ausgesetzt wird, wobei die polymere Schicht (4) als Ätzresist wirkt, und durch den der Materialabtrag des Trägersubstrats (1) entlang der mindestens einen geschlossenen und/oder linienförmigen Kontur und/oder an den punktuellen Modifikationen (5) der lasermodifizierten Bereiche (2) erfolgt, bis sich die so erzeugten Ausnehmungen (6) zumindest über einen wesentlichen Teil der Materialstärke (D) des Trägersubstrats (1), insbesondere zwischen der Schicht (4) und einer der Schicht (4) abgewandten Außenfläche des Trägersubstrats (1), erstrecken, und dass anschließend zumindest ein flexibles Glassubstrat (12) in zumindest dem Bereich (2) des Trägersubstrats (1) auf die polymere Schicht (4) aufgebracht wird.

18. Verfahren nach zumindest einem der Ansprüche 1 bis 8 oder 10 bis 17 zur Herstellung zumindest eines Trägersubstrats (1) aus Glas, mit zumindest in einem vorbestimmten Bereich (2) des Trägersubstrats (1) flexiblen, biegbaren und/oder elastischen Eigenschaften, bei dem mehrere Ausnehmungen (6) mittels eines Ätzverfahrens infolge eines Materialabtrags in das Trägersubstrat (1) eingebracht werden, indem innerhalb des Bereichs (2) des Trägersubstrats (1) mittels Laserstrahlung Modifikationen (5) entlang mindestens einer geschlossenen und/oder linienförmigen Kontur und/oder punktuelle Modifikationen (5) in das Trägersubstrat (1) eingebracht werden und zumindest innerhalb des Bereichs (2) zumindest eine flexible, biegbare und/oder elastische, insbesondere transparente, Schicht (4) aus einem Polymer auf das Trägersubstrat (1) aufgebracht wird und dass anschließend zumindest ein flexibles Glassubstrat (12) in zumindest dem Bereich (2) des Trägersubstrats (1) auf die polymere Schicht (4) aufgebracht wird, sodass anschließend der so geschaffene Verbund aus dem Trägersubstrat (1), Glassubstrat (12) und der polymeren Schicht (4) einem Ätzangriff ausgesetzt wird, durch den der Materialabtrag des Trägersubstrats (1) entlang der mindestens einen geschlossenen und/oder linienförmigen Kontur und/oder an den punktuellen Modifikationen (5) der lasermodifizierten Bereiche (2) erfolgt, bis sich die so erzeugten Ausnehmungen (6) zumindest über einen wesentlichen Teil der Materialstärke (D) des Trägersubstrats (1), insbesondere zwischen der Schicht (4) und einer der Schicht (4) abgewandten Außenfläche (11) des Trägersubstrats (1), erstrecken.

19. Verfahren nach Anspruch 17 oder 18, **dadurch gekennzeichnet, dass** das Glassubstrat (12) flexible und/oder elastische Eigenschaften aufweist und eine Materialstärke wesentlich geringer als das Trägersubstrat (1), insbesondere kleiner als 100 µm oder kleiner als 50 µm, aufweist.

20. Verfahren zur Herstellung eines Trägersubstrats (1) aus Glas für ein Display, mit zumindest in einem vorbestimmten Bereich (2) des Trägersubstrats (1) flexiblen, biegbaren und/oder elastischen Eigenschaften, bei dem mehrere Ausnehmungen (6) mittels eines Ätzverfahrens infolge eines Materialabtrags in das Trägersubstrat (1) eingebracht werden, indem innerhalb des Bereichs (2) des Trägersubstrats (1) mittels Laserstrahlung Modifikationen (5) entlang mindestens einer geschlossenen und/oder linienförmigen Kontur und/oder punktuelle Modifikationen (5) in das Trägersubstrat (1) eingebracht werden und nachfolgend das Trägersubstrat (1) einem Ätzangriff ausgesetzt wird, durch den der Materialabtrag des Trägersubstrats (1) entlang der mindestens einen geschlossenen und/oder linienförmigen Kontur und/oder an den punktuellen Modifikationen (5) der lasermodifizierten Bereiche (2) erfolgt, bis sich die so erzeugten Ausnehmungen (6) als Durchgangsöffnungen zwischen den gegenüberliegenden Außenflächen (11) des Trägersubstrats (1) erstrecken und dadurch ein Festkörpergelenk bilden, und dass schließlich zumindest innerhalb des Bereichs (2) zumindest eine flexible, biegbare und/oder elastische Schicht (4) auf das Trägersubstrat (1) aufgebracht wird.

21. Verfahren nach Anspruch 17 oder 18, **dadurch gekennzeichnet, dass** die polymere Schicht (4) durch ein UV-härtbares Flüssigpolymer gebildet wird.

22. Verfahren nach Anspruch 17, 18 oder 21, **dadurch gekennzeichnet, dass** die polymere Schicht (4) in einem fließfähigen Zustand mittels einer Druckdifferenz, insbesondere mittels Unterdrucks, durch die als Durchgangsöffnungen in dem Trägersubstrat (1) erzeugten Ausnehmungen (6) hindurchgeleitet und anschließend insbesondere mittels UV-Strahlung ausgehärtet wird.

## Claims

1. Method for producing a carrier substrate (1) made of glass for a display having flexible, bendable and/or elastic properties at least in a predetermined region (2) of the carrier substrate (1), in which a plurality of recesses (6) are introduced into the carrier substrate (1) as a result of material removal by means of an etching process, by introducing, within the region (2) of the carrier substrate (1), modifications (5) along at least one closed and/or linear contour and/or punctiform modifications (5) into the carrier substrate (1) by means of laser radiation and applying, at least within the region (2), at least one flexible, bendable and/or elastic layer (4) to the carrier substrate (1) and subsequently exposing a side of the carrier substrate (1) that faces away from the layer (4) to an etching attack via which material is removed from the carrier substrate (1) along the closed and/or linear contour and/or the punctiform modification (5) of the laser-modified regions (2) until the recesses (6) thus created extend at least over a substantial portion of the material thickness (D) of the carrier substrate (1), in particular between the layer (4) and an outer surface (11) of the carrier substrate (1) that faces away from the layer (4), and thereby form a flexure hinge.

2. Method according to Claim 1, **characterized in that** a sacrificial layer is applied, as carrier for the layer (4), to the carrier substrate (1), and **in that** the etching operation is continued until the sacrificial layer is reached to result in dissolution or reduction of the sacrificial layer and ultimately to separation of the connection of the area of the carrier substrate (1) delimited by the contour from the surrounding glass substrate and from the layer (4).

3. Method according to Claim 1 or 2, **characterized in that** a plurality of parallel contours are created in the region (2) of the carrier substrate (1).

4. Method according to at least one of the preceding claims, **characterized in that** the layer (4) applied is a thin-film component, in particular an organic light-emitting diode (OLED) and/or **in that** the layer (4) serves as a carrier for the thin-film component.

5. Method according to at least one of the preceding claims, **characterized in that** the modifications (5) are introduced into the carrier substrate (1) before the layer (4) is applied and/or the etching process is conducted after application of the layer has concluded.

6. Method according to at least one of the preceding claims, **characterized in that** the layer (4) is applied both to the region of the carrier substrate (1) that has been made flexible by the removal of material and also to adjoining regions of the carrier substrate (1).

7. Method according to at least one of the preceding claims, **characterized in that** the etching attack is limited by means of an etch resist on a subregion of the carrier substrate (1).

8. Method according to at least one of the preceding claims, **characterized in that** the recesses in the flexible region are filled with a flexible and/or stretchable polymer.

9. A cover glass (1), intended for a flexible display, made of glass having at least one flexible region (2), in which a plurality of recesses (6) are introduced into the cover glass (1) as a result of material removal by means of an etching process, produced by introducing, within the flexible region (2) to be produced of the cover glass (1), modifications (5) along at least one closed and/or linear contour and/or punctiform modifications (5) into the cover glass (1) by means of laser radiation and subsequently exposing the cover glass (1) to an etching attack via which material is removed from the cover glass (1) along the at least one closed and/or linear contour and/or at the punctiform modifications (5) of the laser-modified regions (2) until the recesses (6) thus created extend at least over a substantial portion of the material thickness of the cover glass (1) and a flexure hinge is formed in the flexible region (2).

10. Method according to at least one of the preceding Claims 1 to 8 or cover glass according to Claim 9, **characterized in that** the flexure hinge is a torsion hinge.

11. Method or cover glass according to Claim 10, **characterized in that** the torsion hinge is formed by cuts, of which at least individual ones have a width b < 100 µm.

12. Method or cover glass according to Claim 11, **characterized in that** the cuts are spaced apart from one another by webs having a width p > 100 µm.

13. Method or cover glass according to Claim 11 or 12, **characterized in that** the cuts have a length of 1 > 300 µm.

14. Method or cover glass according to at least one of Claims 11 to 13, **characterized in that** the cuts have a spacing of d > 100 µm along their longitudinal extent.

15. Method or cover glass according to at least one of Claims 11 to 14, **characterized in that** the length 1 of the cuts is at least three times as great as the spacing d.

16. Method or cover glass according to at least one of the preceding claims, **characterized in that** the flexible region is formed by reducing the material thickness (t₀) by the etching attack, solely in the region of the modifications (5), to a thickness (t₁) at which the carrier substrate (1) made of glass becomes flexible.

17. Method according to at least one of Claims 1 to 8 or 10 to 16, for producing at least one carrier substrate (1) made of glass having flexible, bendable and/or elastic properties at least in a predetermined region (2) of the carrier substrate (1), in which a plurality of recesses (6) are introduced into the carrier substrate (1) as a result of material removal by means of an etching process, by introducing, within the region (2) of the carrier substrate (1), modifications (5) along at least one closed and/or linear contour and/or punctiform modifications (5) into the carrier substrate (1) by means of laser radiation and applying, at least within the region (2), at least one flexible, bendable and/or elastic, in particular transparent, layer (4) made of a polymer to the carrier substrate (1) and exposing the carrier substrate (1) to an etching attack, wherein the polymeric layer (4) acts as an etch resist, and via which material is removed from the carrier substrate (1) along the at least one closed and/or linear contour and/or the punctiform modifications (5) of the laser-modified regions (2) until the recesses (6) thus created extend at least over a substantial portion of the material thickness (D) of the carrier substrate (1), in particular between the layer (4) and an outer surface of the carrier substrate (1) that faces away from the layer (4), and then applying at least one flexible glass substrate (12) to the polymeric layer (4) at least in the region (2) of the carrier substrate (1).

18. Method according to at least one of Claims 1 to 8 or 10 to 17, for producing at least one carrier substrate (1) made of glass, having flexible, bendable and/or elastic properties at least in a predetermined region (2) of the carrier substrate (1), in which a plurality of recesses (6) are introduced into the carrier substrate (1) as a result of material removal by means of an etching process, by introducing, within the region (2) of the carrier substrate (1), modifications (5) along at least one closed and/or linear contour and/or punctiform modifications (5) into the carrier substrate (1) by means of laser radiation and applying, at least within the region (2), at least one flexible, bendable and/or elastic, in particular transparent, layer (4) made of a polymer to the carrier substrate (1) and then applying at least one flexible glass substrate (12) to the polymeric layer (4) at least in the region (2) of the carrier substrate (1) such that the composite thus produced from the carrier substrate (1), glass substrate (12) and the polymeric layer (4) is then exposed to an etching attack, via which material is removed from the carrier substrate (1) along the at least one closed and/or linear contour and/or at the punctiform modifications (5) of the laser-modified regions (2) until the recesses (6) thus created extend at least over a substantial portion of the material thickness (D) of the carrier substrate (1), in particular between the layer (4) and an outer surface (11) of the carrier substrate (1) that faces away from the layer (4).

19. Method according to Claim 17 or 18, **characterized in that** the glass substrate (12) has flexible and/or elastic properties and has a substantially lower material thickness than the carrier substrate (1), in particular less than 100 µm or less than 50 µm.

20. Method for producing a carrier substrate (1) made of glass for a display, having flexible, bendable and/or elastic properties at least in a predetermined region (2) of the carrier substrate (1), in which a plurality of recesses (6) are introduced into the carrier substrate (1) as a result of material removal by means of an etching process, by introducing, within the region (2) of the carrier substrate (1), modifications (5) along at least one closed and/or linear contour and/or punctiform modifications (5) into the carrier substrate (1) by means of laser radiation and subsequently exposing the carrier substrate (1) to an etching attack via which material is removed from the carrier substrate (1) along the at least one closed and/or linear contour and/or at the punctiform modifications (5) of the laser-modified regions (2) until the recesses (6) thus created extend as through-openings between the opposite outer surfaces (11) of the carrier substrate (1) and thereby form a flexure hinge, and lastly applying at least one flexible, bendable and/or elastic layer (4) to the carrier substrate (1) at least within the region (2).

21. Method according to Claim 17 or 18, **characterized in that** the polymeric layer (4) is formed by a UV-curable liquid polymer.

22. Method according to Claim 17, 18 or 21, **characterized in that** the polymeric layer (4) is passed in a flowable state by means of a pressure difference, in particular by means of negative pressure, through the recesses (6) created in the carrier substrate (1) as through-openings and then cured in particular by means of UV radiation.

## Revendications

1. Procédé de fabrication d'un substrat de support (1) en verre destiné à un afficheur, des propriétés flexibles, pliables et/ou élastiques étant présentes au moins dans une zone prédéterminée (2) du substrat de support (1), procédé dans lequel plusieurs évidements (6) sont ménagés dans le substrat de support (1) au moyen d'un procédé de gravure par enlèvement de matière en ce que des modifications (5) le long d'au moins un contour fermé et/ou linéaire et/ou des modifications ponctuelles (5) sont apportées dans le substrat de support (1) au moyen d'un rayonnement laser dans la zone (2) du substrat de support (1) et au moins une couche flexible, pliable et/ou élastique (4) est appliquée sur le substrat de support (1) au moins dans la zone (2) puis un côté du substrat de support (1) opposé à la couche (4) étant soumis à une attaque par gravure qui permet d'effectuer l'enlèvement de matière du substrat de support (1) le long du contour fermé et/ou linéaire et/ou de la modification ponctuelle (5) des zones (2) modifiées par laser jusqu'à ce que les évidements (6) ainsi générés s'étendent au moins sur une partie importante de l'épaisseur de matière (D) du substrat de support (1), en particulier entre la couche (4) et une surface extérieure (11) du substrat de support (1) opposée à la couche (4) et forment ainsi une articulation monolithique.

2. Procédé selon la revendication 1, **caractérisé en ce qu'**une couche sacrificielle est appliquée comme support de la couche (4) sur le substrat de support (1), et **en ce que** le processus de gravure est poursuivi jusqu'à ce que la couche sacrificielle soit atteinte, de façon à obtenir une dissolution ou une réduction de la couche sacrificielle et finalement une séparation de la liaison entre la surface du substrat de support (1), délimitée par le contour, et le substrat en verre environnant ainsi que la couche (4).

3. Procédé selon la revendication 1 ou 2, **caractérisé en ce que** plusieurs contours parallèles sont générés dans la zone (2) du substrat de support (1).

4. Procédé selon l'une au moins des revendications précédentes, **caractérisé en ce qu'**un composant à couche mince, en particulier une diode électroluminescente organique (OLED), est appliqué comme couche (4) et/ou **en ce que** la couche (4) sert de support du composant à couche mince.

5. Procédé selon l'une au moins des revendications précédentes, **caractérisé en ce que** les modifications (5) sont apportées dans le substrat de support (1) avant l'application de la couche (4) et/ou le processus de gravure est effectué après que l'application de la couche est achevée.

6. Procédé selon l'une au moins des revendications précédentes, **caractérisé en ce que** la couche (4) est appliquée aussi bien sur la zone du substrat de support (1) qui est flexible en raison de l'enlèvement de matière que sur des zones adjacentes du substrat de support (1).

7. Procédé selon l'une au moins des revendications précédentes, **caractérisé en ce que** l'attaque par gravure est limitée à une partie de zone du substrat de support (1) au moyen d'une résine de gravure.

8. Procédé selon l'une au moins des revendications précédentes, **caractérisé en ce que** les évidements dans la zone flexible sont remplis d'un polymère flexible et/ou extensible.

9. Verre de recouvrement (1) en verre destinée à un afficheur flexible et comportant au moins une zone flexible (2) dans laquelle plusieurs évidements (6) sont ménagés dans le verre de recouvrement (1) au moyen d'un procédé de gravure par enlèvement de matière, ledit verre de recouvrement étant fabriqué par apport de modifications (5) le long d'au moins un contour fermé et/ou linéaire et/ou de modifications ponctuelles (5) dans le verre de recouvrement (1) à l'intérieur de la zone flexible (2) à réaliser du verre de recouvrement (1) au moyen d'un rayonnement laser, puis par soumission du verre de recouvrement (1) à une attaque par gravure qui permet l'enlèvement de matière du verre de recouvrement (1) le long d'au moins un contour fermé et/ou linéaire et/ou au niveau des modifications ponctuelles (5) des zones (2) modifiées par laser jusqu'à ce que les évidements (6) ainsi générés s'étendent au moins sur une partie importante de l'épaisseur de matière du verre de recouvrement (1) et qu'une articulation monolithique soit réalisée dans la zone flexible (2).

10. Procédé selon l'une au moins des revendications précédentes 1 à 8 ou verre de recouvrement selon la revendication 9, **caractérisé en ce que** l'articulation monolithique est une articulation à torsion.

11. Procédé ou verre de recouvrement selon la revendication 10, **caractérisé en ce que** l'articulation à torsion est formée par des découpes dont au moins certaines ont une largeur b < 100 µm.

12. Procédé ou verre de recouvrement selon la revendication 11, **caractérisé en ce que** les découpes sont espacées les unes des autres par des bandes de largeur p > 100 µm.

13. Procédé ou verre de recouvrement selon la revendication 11 ou 12, **caractérisé en ce que** les découpes ont une longueur de 1 > 300 µm.

14. Procédé ou verre de recouvrement selon l'une au moins des revendications 11 à 13, **caractérisé en ce que** les découpes présentent une distance d > 100 µm le long de leur grande extension.

15. Procédé ou verre de recouvrement selon l'une au moins des revendications 11 à 14, **caractérisé en ce que** la longueur 1 des découpes est au moins trois fois plus grande que la distance d.

16. Procédé ou verre de recouvrement selon l'une au moins des revendications précédentes, **caractérisé en ce que** la zone flexible est formée de manière que l'épaisseur de matière (t₀) soit réduite par l'attaque par gravure uniquement dans la zone des modifications (5) sur une épaisseur (t₁) à laquelle le substrat de support (1) en verre devient flexible.

17. Procédé selon l'une au moins des revendications 1 à 8 ou 10 à 16, destiné à la fabrication d'au moins un substrat de support (1) en verre présentant des propriétés flexibles, pliables et/ou élastiques au moins dans une zone prédéterminée (2) du substrat de support (1), procédé dans lequel plusieurs évidements (6) sont ménagés dans le substrat de support (1) au moyen d'un procédé de gravure par enlèvement de matière, par apport de modifications (5) le long d'au moins un contour fermé et/ou linéaire et/ou de modifications ponctuelles (5) dans le substrat de support (1) à l'intérieur de la zone (2) du substrat de support (1) au moyen d'un rayonnement laser et par application, au moins à l'intérieur de la zone (2), d'au moins une couche de polymère (4) flexible, pliable et/ou élastique, en particulier transparente, sur le substrat de support (1) et par soumission du substrat de support (1) à une attaque de gravure, la couche de polymère (4) agissant comme une résine de gravure et l'enlèvement de matière du substrat de support (1) s'effectuant le long des au moins un contour fermé et/ou linéaire et/ou au niveau des modifications ponctuelles (5) des zones (2) modifiées par laser jusqu'à ce que les évidements (6) ainsi générés s'étendent au moins sur une partie importante de l'épaisseur de matière (D) du substrat de support (1), en particulier entre la couche (4) et une surface extérieure du substrat de support (1) opposée à la couche (4), puis au moins un substrat en verre flexible (12) étant appliqué sur la couche de polymère (4) dans au moins la zone (2) du substrat de support (1).

18. Procédé selon l'une au moins des revendications 1 à 8 ou 10 à 17 destiné à la fabrication d'au moins un substrat de support (1) en verre présentant des propriétés flexibles, pliables et/ou élastiques au moins dans une zone prédéterminée (2) du substrat de support (1), procédé dans lequel plusieurs évidements (6) sont introduits dans le substrat de support (1) au moyen d'un procédé de gravure par enlèvement de matière par apport de modifications (5) le long d'au moins un contour fermé et/ou linéaire et/ou de modifications ponctuelles (5) dans le substrat de support (1) à l'intérieur de la zone (2) du substrat de support (1) au moyen d'un rayonnement laser et par application, au moins à l'intérieur de la zone (2), d'au moins une couche de polymère (4) flexible, pliable et/ou élastique, en particulier transparente, sur le substrat de support (1) puis par application d'au moins un substrat en verre flexible (12) sur la couche de polymère (4), de sorte que le composite ainsi créé à partir du substrat de support (1), du substrat de verre (12) et de la couche de polymère (4) soit ensuite soumis à une attaque par gravure qui permet d'effectuer l'enlèvement de matière du substrat de support (1) le long de l'au moins un contour fermé et/ou linéaire et/ou au niveau des modifications ponctuelles (5) des zones (2) modifiées au laser jusqu'à ce que les évidements (6) ainsi créés s'étendent au moins sur une partie importante de l'épaisseur de matière (D) du substrat de support (1), en particulier entre la couche (4) et une surface extérieure (11) du substrat de support (1) opposée à la couche (4).

19. Procédé selon la revendication 17 ou 18, **caractérisé en ce que** le substrat en verre (12) présente des propriétés flexibles et/ou élastiques et a une épaisseur de matière sensiblement inférieure à celle du substrat de support (1), en particulier inférieure à 100 µm ou inférieure à 50 µm.

20. Procédé de fabrication d'un substrat de support (1) en verre destiné à un afficheur et présentant des propriétés flexibles, pliables et/ou élastiques au moins dans une zone prédéterminée (2) du substrat de support (1), procédé dans lequel plusieurs évidements (6) sont ménagés dans le substrat de support (1) au moyen d'un procédé de gravure par enlèvement de matière, par apport de modifications (5) le long d'au moins un contour fermé et/ou linéaire et/ou de modifications ponctuelles (5) dans le substrat de support (1) à l'intérieur de la zone (2) du substrat de support (1) au moyen d'un rayonnement laser puis par soumission du substrat de support (1) à une attaque par gravure qui permet d'effectuer l'enlèvement de matière du substrat de support (1) le long d'au moins un contour fermé et/ou linéaire et/ou au niveau des modifications ponctuelles (5) des zones (2) modifiées par laser jusqu'à ce que les évidements (6) ainsi créés s'étendent comme des ouvertures traversantes entre les surfaces extérieures opposées (11) du substrat de support (1) et forment ainsi une articulation monolithique, et qu'enfin au moins une couche flexible, pliable et/ou élastique (4) soit appliquée sur le substrat de support (1) au moins à l'intérieur de la zone (2).

21. Procédé selon la revendication 17 ou 18, **caractérisé en ce que** la couche de polymère (4) est formée par un polymère liquide durcissable aux UV.

22. Procédé selon la revendication 17, 18 ou 21, **caractérisé en ce que** la couche de polymère (4) est amenée à l'état fluide au moyen d'une différence de pression, notamment au moyen d'une dépression, à travers les évidements (6) réalisés sous forme d'ouvertures traversantes dans le substrat de support (1) puis est durcie notamment au moyen d'un rayonnement UV.
